# EUROPEAN PATENT APPLICATION

(11) **EP 3 798 728 A1**
(43) Date of publication of application: **31.03.2021**
(21) Application number: 19219207.8
(22) Date of filing: 23.12.2019
(51) Int. Cl.: G03F 1/62, G03F 1/64

(54) **PELLICLE FOR EUV LITHOGRAPHY AND METHOD FOR MANUFACTURING THE SAME**

(30) Priority: 26.09.2019 KR 20190118950; 05.11.2019 KR 20190140372
(71) Applicant: S&S Tech Co., Ltd., Daegu-si 42714 (KR)
(72) Inventor: NAM, Kee-Soo, 42714 Daegu-si (KR); LEE, Chang-Hun, 42714 Daegu-si (KR); YUN, Jong-Won, 42714 Daegu-si (KR); PARK, Chul-Kyun, 42714 Daegu-si (KR)
(74) Representative: ABG Intellectual Property Law, S.L.

(57) **Abstract**

Disclosed is a pellicle for extreme ultraviolet (EUV) lithography, with a core layer (10) formed on a pellicle frame (90), the core layer comprising: a first layer (11); and a second layer (12). The first layer includes silicon. The second layer includes one among a metal silicide that has silicon with metal, a silicon compound that has silicon with a light element, and a metal silicide compound that has silicon with metal and a light element. With this, the pellicle is improved in mechanical, thermal and chemical stability with minimum loss of optical characteristics.

## Description

### CROSS-REFERENCE TO RELATED APPLICATION

This application claims priorities from Korean Patent Application Nos. 10-2019-0118950 filed on September 26, 2019 and 10-2019-0140372 filed on November 5, 2019 in the Korean Intellectual Property Office, the disclosure of which is incorporated by reference herein in its entirety.

### BACKGROUND

### Field

The disclosure relates to a pellicle for extreme ultraviolet (EUV) lithography and a method of manufacturing the same, and more particularly to a pellicle for EUV lithography, which satisfies transmittance higher than or equal to 85% and reflectivity lower than or equal to 1% with respect to EUV exposure light, and a method of manufacturing the same.

### Description of the Related Art

Development of exposure technology called photolithography has made it possible for a semiconductor integrated circuit (IC) to have high integration. To form a finer circuit pattern on a wafer, resolution (also referred to as a limit of resolution) in exposure equipment has to become higher. When a fine pattern beyond the limit of resolution is transferred, there is a problem that a distorted image different from an original mask pattern is transferred because of light interference caused by diffraction and scattering.

A currently commercialized exposure process employs exposure equipment using an ArF wavelength of 193nm to perform a transfer process and form a fine pattern on a wafer, but is limited due to diffraction and scattering of light in terms of forming a fine pattern of 50nm or less. Accordingly, there have been developed various methods such as immersion lithography of using a liquid medium having a higher refractive index than air; double lithography of performing exposure twice; phase shift technology of shifting a phase of light by 180 degrees and causing a destructive interference with adjacent transmission light; optical phase correction of correcting a small size or rounded end of a designed pattern caused by the interference and diffraction of light; etc.

However, the exposure technology using the ArF wavelength is not only difficult to get a finer circuit line width narrower than or equal to 32nm, but also increases production costs and process complexity. Therefore, extreme ultraviolet (EUV) photolithography technology, in which a wavelength of 13.5nm very shorter than the wavelength of 193nm is used for a main exposure wavelength, has attracted attention as the next-generation process.

Meanwhile, the lithography process employs a photomask as an original plate for patterning, and a pattern on the photomask is transferred to a wafer. In this case, if the photomask is attached with impurities such as particles, foreign materials, etc., the impurities may damage the pattern transferred after absorbing or reflecting the exposure light and thus cause reduction in performance or yield of the semiconductor device.

To prevent the surface of the photomask from being attached with impurities, a method of attaching a pellicle to the photomask is being used. The pellicle is attached to the top surface of the photomask, and therefore the impurities on the pellicle are out of focus and not transferred to the surface of the wafer since the pattern of the photomask is in focus at a photolithography process even though impurities are attached to the pellicle. With recent fineness of the circuit line width, the size of impurities that may have an effect on the damage of the pattern is decreased, thereby increasing importance of the pellicle for protecting the photomask.

### SUMMARY

Accordingly, an aspect of one or more exemplary embodiments may provide a pellicle for extreme ultraviolet (EUV) lithography, which is improved in mechanical, thermal and chemical stability with minimum loss of optical characteristics, and a method of manufacturing the same.

According to one embodiment of the disclosure, there is provided a pellicle for extreme ultraviolet (EUV) lithography, with a core layer formed on a pellicle frame, the core layer including: a first layer including silicon; and a second layer formed on at least one of an upper side and a lower side of the first layer, and including one among a metal silicide that has silicon with metal, a silicon compound that has silicon with a light element, and a metal silicide compound that has silicon with metal and a light element.

The light element may include one or more among oxygen (O), nitrogen (N), and carbon(C).

The metal may include one or more between molybdenum (Mo) and ruthenium (Ru)

The second layer may include one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2) and RuSi_{X}C_{Y}O_{Z} (X = 0-3, Y=0-2, Z=0-2).

The second layer may be formed on each side of the first layer.

The second layer is formed on only the upper side of the first layer, and the first layer may include monocrystalline silicon.

A capping layer may be further formed on at least one between the upper side and the lower side of the core layer, and including one among a metal silicide that has silicon with metal, a silicon compound that has silicon with a light element, and a metal silicide compound that has silicon with metal and a light element.

The capping layer may include one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2), and RuSi_{X}C_{Y}O_{Z} (X = 0-3, Y=0-2, Z=0-2).

An interface layer may be formed at an interface between the core layer and the capping layer, an interface between the first layer and the second layer, or an interface between a plurality of capping layers; or a surface layer may be formed on a surface of an outermost layer of the capping layers having a multi-layered thin film structure.

The core layer may have transmittance higher than or equal to 85% and reflectivity lower than or equal to 1% with respect to EUV exposure light.

The core layer may have a thickness lower than or equal to 100nm.

Materials of a plurality of layers formed by the core layer and the capping layer may be stacked in order along an incident direction of exposure light by one of the following structures:

SiCₓO_{y}/MoSi_{X}C_{Y}O_{Z}/SiNₓ/Si/SiCₓO_{y};

SiCₓO_{y}/MoSi_{X}C_{Y}O_{Z}/Si/SiNₓ;

MoSi_{X}C_{Y}O_{Z}/SiNₓ/Si/SiCₓO_{y};

MoSiₓC_{Y}O_{Z}/Si/SiNₓ;

RuSiₓ/SiNₓ/Si/SiCₓO_{y};

RuSi_{X}C_{Y}O_{Z}/Si/SiNₓ;

SiNₓ/Si/MoSi_{X}C_{Y}O_{Z}/SiCₓO_{y};

SiNₓ/Si/MoSi_{X}C_{Y}O_{Z};

SiNₓ/Si/RuSi_{X}C_{Y}O_{Z};

SiCₓO_{y}/MoSi_{X}C_{Y}O_{Z}/Si/SiCₓO_{y};

SiCₓO_{y}/Si/MoSi_{X}C_{Y}O_{Z}/SiCₓO_{y};

MoSi_{X}C_{Y}O_{Z}/Si/SiCₓO_{y};

SiCₓO_{y}/Si/MoSi_{X}C_{Y}O_{Z};

RuSi_{X}C_{Y}O_{Z}/Si/SiCₓO_{y};

and

SiCₓO_{y}/Si/RuSi_{X}C_{Y}O_{Z}.

According to another embodiment of the disclosure, there is provided a method of manufacturing a pellicle for extreme ultraviolet (EUV) lithography, the method including: forming an etching stop layer on a substrate; forming a core layer on the etching stop layer; forming an etching protective layer on the core layer, and forming an etching mask layer pattern beneath the substrate; forming a pellicle frame by etching a lower portion of the substrate and the etching stop layer through the etching mask layer pattern; and removing the etching protective layer. Here, the core layer may include: a first layer including silicon; and a second layer formed on at least one of an upper side and a lower side of the first layer, and including one among a metal silicide that has silicon with metal, a silicon compound that has silicon with a light element, and a metal silicide compound that has silicon with metal and a light element.

The method may further include forming a capping layer at least either above or below the core layer.

The capping layer formed above the core layer may be formed before forming the etching protective layer or after removing the etching protective layer.

The capping layer formed below the core layer may be formed before forming the core layer or after forming the pellicle frame.

The core layer or the capping layer may be formed based on sputtering using a sputtering target having a composition of silicon/metal=0.05-20, or a sputtering target having a composition of compound (of one or more among O, C, and N)/silicon=0.1-4, at a temperature of 20-600 °C.

The method may further include annealing the capping layer at a temperature higher than or equal to 150 °C under an atmosphere of nitrogen (N), argon (Ar), hydrogen (H), hydrocarbon, or a mixture thereof.

According to still another embodiment of the disclosure, there is provided a method of manufacturing a pellicle for extreme ultraviolet (EUV) lithography, using a silicon-on-insulator (SOI) substrate having a structure that a silicon substrate layer, an insulating layer, and a silicon layer are stacked in sequence, while regarding the silicon substrate layer as a pellicle frame, regarding the silicon layer as a first layer of a core layer, and regarding the insulating layer as an etching stop layer, the method including: forming a second layer, which includes one among a metal silicide that has silicon with metal, a silicon compound that has silicon with a light element, and a metal silicide compound that has silicon with metal and a light element, on the first layer of the core layer; forming an etching protective layer above the second layer and forming an etching mask layer pattern below the silicon substrate layer; forming the pellicle frame by etching a lower portion of the silicon substrate layer through the etching mask layer pattern; and removing the etching protective layer.

The method may further including forming a capping layer at least either above or below the core layer.

The capping layer formed above the core layer may be formed before forming the etching protective layer or after removing the etching protective layer.

The core layer or the capping layer may be formed based on sputtering using a sputtering target having a composition of metal:silicon=1:0.1-3, or a sputtering target having a composition of silicon:compound (of one or more among O, C, and N)=0.1-4.

The method may further include annealing the capping layer at a temperature higher than or equal to 150 °C under an atmosphere of nitrogen (N), argon (Ar), hydrogen (H), hydrocarbon, or a mixture thereof.

### BRIEF DESCRIPTION OF THE DRAWINGS

The above and/or other aspects will become apparent and more readily appreciated from the following description of exemplary embodiments, taken in conjunction with the accompanying drawings, in which:
FIG. 1 is a cross-section view of a pellicle for extreme ultraviolet (EUV) lithography according to a first embodiment of the disclosure;
FIG. 2 is a cross-section view of a pellicle for EUV lithography according to a second embodiment of the disclosure;
FIG. 3 is a cross-section view of a pellicle for EUV lithography according to a third embodiment of the disclosure; and
FIGS. 4 to 8 are views of sequentially illustrating a method of manufacturing the pellicle according to the first and second embodiments shown in FIGS. 1 and 2.

### DETAILED DESCRIPTION OF EXEMPLARY EMBODIMENTS

Below, embodiments of the disclosure will be described in detail with reference to the accompanying drawings.

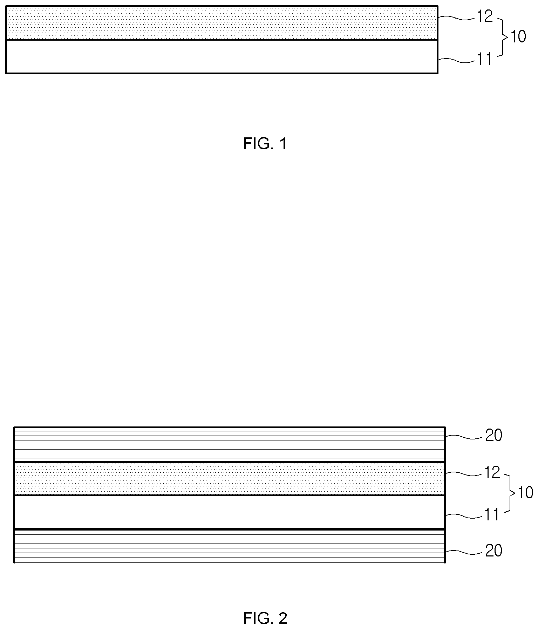

FIG. 1 is a cross-section view of a pellicle for extreme ultraviolet (EUV) lithography according to a first embodiment of the disclosure.

The pellicle for the EUV lithography according to the first embodiment of the disclosure includes a core layer 10 through which EUV exposure light is transmitted, and the core layer 10 includes a first layer 11 and a second layer 12.

The first layer 11 includes monocrystalline, polycrystalline or amorphous silicon. Silicon has high transmittance, but low mechanical strength, thermal characteristics and chemical stability.

The second layer 12 includes a material that is excellent in mechanical strength, thermal characteristics and chemical stability while maintaining high transmittance with respect to the EUV exposure light. To this end, the second layer 12 includes one among a metal silicide that has silicon with metal, a silicon compound that has silicon with a light element, and a metal silicide compound that has silicon with metal and a light element. The light element of the silicon compound may include one or more among oxygen (O), nitrogen (N) and carbon(C). Metal of the metal silicide refers to transition metal which has an atomic number less than 80 in the periodic table, and may include one or more between molybdenum (Mo) and ruthenium (Ru).

Specifically, the second layer 12 may include one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2) and RuSi_{X}C_{Y}O_{Z} (X = 0-3, Y=0-2, Z=0-2).

The core layer 10 has transmittance higher than or equal to 85% and reflectivity lower than or equal to 1% with respect to EUV exposure light. To this end, the layers 11 and 12 of the core layer 10 may have various thickness combinations. The core layer 10 may have a thickness lower than or equal to 100nm.

Although it is not shown in FIG. 1, the pellicle for EUV lithography according to the disclosure includes a pellicle frame that serves to not only support the core layer 10 but also make a completed pellicle be easily handled and transferred. The pellicle frame includes a material that can be subjected to a dry/wet etching process, and may for example be formed by applying an etching process or a micromachining technique to quartz, a silicon-on-insulator (SOI) substrate, or a silicon wafer. Below, it will be assumed that the pellicle according to an embodiment of the disclosure includes the pellicle frame, even though there are no specific mention of the pellicle frame.

The second layer 12 may be formed on each side of the first layer 11, on only an upper side of the first layer 11, or on only a lower side of the first layer 11.

When the second layer 12 is formed on only the upper side of the first layer 11, the first layer 11 may include monocrystalline silicon. Because monocrystalline silicon has higher optical transmittance than polycrystalline or amorphous silicon, it is preferable that the first layer 11 is made of monocrystalline silicon. However, it is difficult to form monocrystalline silicon on another layer through deposition or the like. Therefore, when the second layer 12 is disposed beneath the first layer 11, it is difficult to use monocrystalline silicon to form the first layer 11 after forming the second layer 12. However, for example, the SOI substrate including a silicon substrate layer, an insulating layer, and a silicon layer may be used to form the first layer 11 with monocrystalline silicon. In other words, when the silicon layer, i.e. the uppermost layer of the SOI substrate is used as the first layer 11 and the second layer 12 is formed on the first layer 11, it is possible to use monocrystalline silicon for the first layer 11. Therefore, when the SOI substrate is used, the first layer 11 is made of monocrystalline silicon to thereby achieve the pellicle showing a very good transmittance. A detailed method of using the SOI substrate according to the disclosure will be described later.

FIG. 2 is a cross-section view of a pellicle for EUV lithography according to a second embodiment of the disclosure.

The pellicle according to this embodiment includes a core layer 10 and a capping layer 20, and the core layer 10 has the same structure as that of the embodiment shown in FIG. 1. The capping layers 20 are provided on the upper side and the lower side of the core layer 10, respectively. Alternatively, the capping layer 20 may be provided on only one between the upper side and the lower side of the core layer 10.

The capping layer 20 serves to protect the core layer 10 from a chemical reaction that occurs under an EUV lithography environment, enhance the mechanical strength of the core layer 10, and radiate heat to improve the thermal stability of the core layer 10. To this end, the capping layer 20 includes materials which has low reactivity with hydrogen (H) radical and oxygen (O), is chemically stable, and mechanically excellent.

The materials of the capping layer 20 may be the same as those of the second layer 12 of the core layer 10. In other words, the capping layer 20 may include one among a metal silicide that has silicon with metal, a silicon compound that has silicon with a light element, and a metal silicide compound that has silicon with metal and a light element. The light element of the silicon compound may include one or more among oxygen (O), nitrogen (N) and carbon(C). Metal of the metal silicide refers to transition metal which has an atomic number less than 80 in the periodic table, and may include at least one of Mo and Ru.

Specifically, the capping layer 20 may include one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2), and RuSi_{X}C_{Y}O_{Z} (X = 0-3, Y=0-2, Z=0-2).

The capping layer 20 has a thickness lower than or equal to 15nm and preferably lower than or equal to 10nm, and may have various thicknesses based on the mechanical strength and optical characteristics of the core layer 10. The capping layer 20 may be formed with a thickness to have as low reflectivity as possible with respect to EUV exposure light. For example, the capping layer 20 may be formed to have an optical thickness to thereby cause destructive interference with EUV exposure light reflected from one or more layers.

To finally make the pellicle have transmittance higher than or equal to 85% and reflectivity lower than or equal to 1% with respect to EUV exposure light, the layers 11 and 12 of the core layer 10 and the capping layer 20 may have various thickness combinations.

Each capping layer 20 may have a single-layer structure or a multi-layer structure. In a case of the multi-layer structure, layers may be different in a composition or a composition ratio.

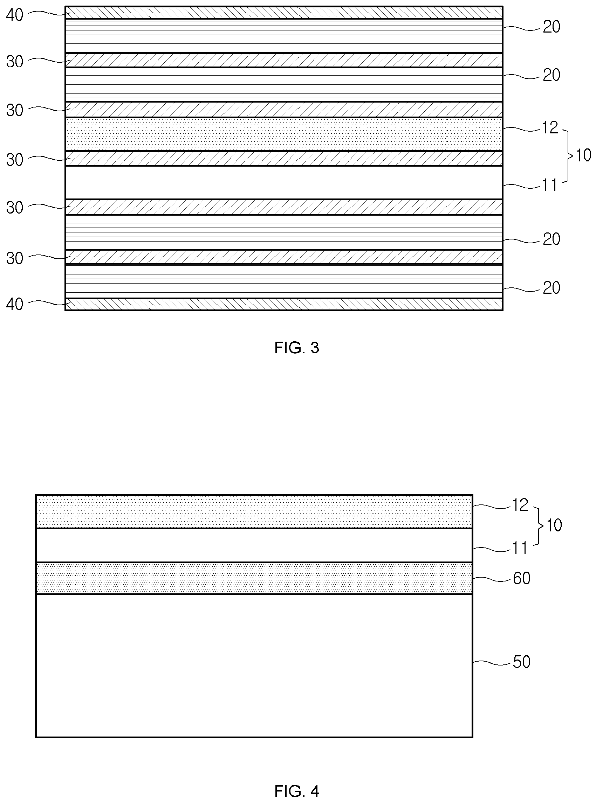

FIG. 3 is a cross-section view of a pellicle for EUV lithography according to a third embodiment of the disclosure.

The pellicle according to this embodiment includes a core layer 10, a capping layer 20, an interface layer 30, and a surface layer 40, and the core layer 10 and the capping layer 20 has the same configuration as those of the embodiment shown in FIG. 2. Further, in this embodiment, two capping layers 20 are provided at each of upper and lower sides of the core layer 10.

The interface layers 30 are provided between the core layer 10 and the capping layer 20, between the first layer 11 and the second layer 12 of the core layer 10, and between the capping layers 20. The surface layer 40 is formed on the surface of the outermost layer of the capping layers 20 having a multi-layered thin film structure. The interface layer 30 and the surface layer 40 may be naturally formed while forming the layers, or may be formed by an artificial forming process. The interface layer 30 and the surface layer 40 may be made of a material different in a composition or a composition ratio from the layers adjacent thereto. The compositions of the interface layer 30 and the surface layer 40 may be linearly or nonlinearly varied depending on positions in a thickness direction, may be varied depending on positions in a planar direction, or may be varied depending on combination of the positions in the thickness and planar directions.

For example, when two adjacent layers are respectively a Si layer and a metal silicide layer, the composition of the metal silicide layer may be varied in the thickness direction on the interface between the Si layer and the metal silicide layer, and this varying portion may form the interface layer 30. Alternatively, when two adjacent layers are respectively a Si layer and a MoSi_{X} layer, the interface layer 30 may be formed to have a composition of MoSi_{X} (X = 0.9) at a position adjacent to the Si layer and a composition of MoSi_{X} (X = 1.1) at a position adjacent to the MoSi_{X} layer, or may be formed to have a composition of MoSi_{X} (X = 1.1) at the position adjacent to the Si layer and a composition of MoSi_{X} (X = 0.9) at the position adjacent to the MoSi_{X} layer.

Besides the foregoing examples of forming the interface layer 30, the interface layer 30, which has various compositions according to the materials of the adjacent layers between which the interface is formed, may be present on the interface. In other words, when one or more layers may be present on the interface between the layers, and the material or composition of the layer present on the interface is formed by combination of the materials of two adjacent layers between which the interface is formed, this may fall into the category of the interface layer 30.

Further, when one or more layers are present on the surface, and the composition of the layer present on the surface is formed by combination of the material of the outermost layer, oxygen (O) and/or carbon (C), this may fall into the category of the surface layer 40.

Among various embodiments of the disclosure, an example of a multi-layered film based on the foregoing structure of the layers is as follows. The following layered structure shows materials of a plurality of layers formed by the core layer (with the first layer and the second layer) and one or more capping layers, which are stacked in order along an incident direction of exposure light:

SiCₓO_{y}/MoSi_{X}C_{Y}O_{Z}/SiNₓ/Si/SiCₓO_{y};

SiCₓO_{y}/MoSi_{X}C_{Y}O_{Z}/Si/SiNₓ;

MoSi_{X}C_{Y}O_{Z}/SiNₓ/Si/SiCₓO_{y};

MoSiₓC_{Y}O_{Z}/Si/SiNₓ;

RuSiₓ/SiNₓ/Si/SiCₓO_{y};

RuSi_{X}C_{Y}O_{Z}/Si/SiNₓ;

SiNₓ/Si/MoSi_{X}C_{Y}O_{Z}/SiCₓO_{y};

SiNₓ/Si/MoSi_{X}C_{Y}O_{Z};

SiNₓ/Si/RuSi_{X}C_{Y}O_{Z};

SiCₓO_{y}/MoSi_{X}C_{Y}O_{Z}/Si/SiCₓO_{y};

SiCₓO_{y}/Si/MoSi_{X}C_{Y}O_{Z}/SiCₓO_{y};

MoSi_{X}C_{Y}O_{Z}/Si/SiCₓO_{y};

SiCₓO_{y}/Si/MoSi_{X}C_{Y}O_{Z};

RuSi_{X}C_{Y}O_{Z}/Si/SiCₓO_{y};

and

SiCₓO_{y}/Si/RuSi_{X}C_{Y}O_{Z}.

FIGS. 4 to 8 are views of sequentially illustrating a method of manufacturing the pellicle according to the first and second embodiments shown in FIGS. 1 and 2.

Referring to FIG. 4, an etching stop layer 60 and a core layer 10 are formed in sequence on a silicon substrate 50. The etching stop layer 60 may for example include a layer made of a silicon oxide film.

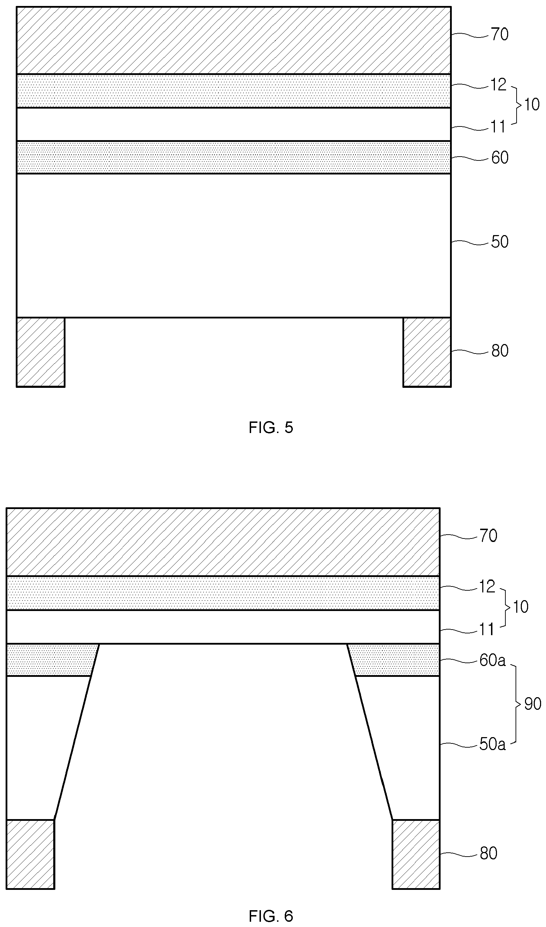

Referring to FIG. 5, an etching protective layer 70 is formed on the core layer 10 to protect the core layer 10 from etching when a lower portion of the silicon substrate 50 is etched, and an etching mask layer pattern 80 is formed beneath the silicon substrate 50. The etching mask layer pattern 80 may be formed using a one-side etching jig or through dry or wet etching.

As shown in FIG. 6, the etching mask layer pattern 80 is used as an etching mask to etch the exposed lower portion of the silicon substrate 50 by the wet etching process using KOH, TMAH, etc., thereby forming a support layer pattern 50a. Then, the etching stop layer 60 is etched to form an etching stop layer pattern 60a, thereby exposing the lower portion of the core layer 10. The support layer pattern 50a and the etching stop layer pattern 60a form a pellicle frame 90 for supporting the core layer 10.

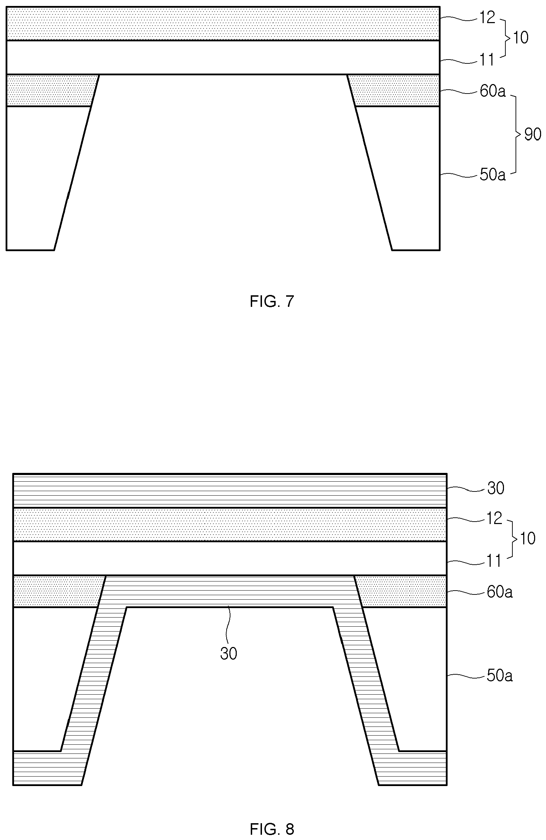

Then, the etching protective layer 70 at an upper side and the etching mask layer pattern 80 at a lower side are removed by the dry or wet etching process, thereby achieving the pellicle having the structure as shown in FIG. 7. The pellicle of FIG. 7 corresponds to the structure according to the first embodiment of the disclosure described with reference to FIG. 1.

By forming the capping layers 20 on and beneath the core layer 10 exposed in the state of FIG. 7, the pellicle having the structure as shown in FIG. 8 is achieved. The pellicle of FIG. 8 corresponds to the structure according to the second embodiment of the disclosure described with reference to FIG. 2. As necessary, the capping layer 20 may be formed on only one of the upper side and the lower side of the core layer 10.

Meanwhile, the etching stop layer 60, the core layer 10, the capping layer 20, the etching protective layer 70, and the etching mask layer pattern 80 described above may be formed by chemical vapor deposition (CVD), physical vapor deposition (PVD) such as sputtering, atomic layer deposition (ALD), thermal oxidation, annealing, or the like method. For example, these layers may be formed by the sputtering using a sputtering target having the same composition as the material of the corresponding layer, a sputtering target having a composition of silicon/metal=0.05-20, or a sputtering target having a composition of compound (of one or more among O, C, and N)/silicon=0.1-4, at a temperature of 20-600 °C. Further, each layer may be annealed at a temperature higher than or equal to 150 °C under an atmosphere of nitrogen (N), argon (Ar), hydrogen (H), hydrocarbon, or a mixture thereof.

Meanwhile, in the manufacturing process, the capping layers 20 may be formed in different order from that of the foregoing embodiments. For example, the foregoing embodiments illustrate that the capping layers 20 formed above the core layer 10 are formed after removing the etching protective layer 70, but the capping layer 20 formed above the core layer 10 may be formed before forming the etching protective layer 70. Further, the foregoing embodiments illustrate that the capping layers 20 formed below the core layer 10 are formed after forming the pellicle frame 90, but the capping layer 20 formed below the core layer 10 may be formed before forming the core layer 10.

Meanwhile, the pellicle of the disclosure may be manufactured using the SOI substrate as described above. In this case of using the SOI substrate, monocrystalline silicon can be used to form the first layer 11 of the core layer 10, thereby further improving transmittance.

The SOI substrate refers to a substrate manufactured in a state that an insulating layer of SiO₂ and a silicon layer have been formed in sequence on a silicon substrate layer. According to the disclosure, the silicon substrate layer, the insulating layer, and the silicon layer in the SOI substrate are respectively used as the support layer pattern 50a, the etching stop layer pattern 60a, and the first layer 11 of the core layer 10 in the finally manufactured pellicle. Therefore, the SOI substrate is in a state that the silicon substrate 50, the etching stop layer 60, and the first layer 11 of the core layer 10 have already been formed in the structure shown in FIG. 5.

In this state, the structure as shown in FIG. 4 is obtained by additionally forming the second layer 12 of the core layer 10 on the SOI substrate. The following processes are the same as those described above with reference to FIGS. 5 to 8, and will be quoted in the method according to an embodiment of the disclosure even though repetitive descriptions thereof are avoided.

According to the disclosure, the pellicle is improved in mechanical, thermal and chemical stability with the minimum loss of optical characteristics, and has transmittance higher than or equal to 85% and reflectivity lower than or equal to 1% with respect to EUV exposure light

Although a few exemplary embodiments of the disclosure have been shown and described using the structures of the disclosure in details with reference to the accompanying drawings, the structures are given for only illustrative purposes without limiting the meaning and scope of the disclosure defined in the appended claims. Therefore, it will be appreciated by a person having an ordinary skill in the art that various changes and equivalents may be made in these structures. Thus, the scope of the disclosure has to be defined by technical matters of the appended claims.

## Claims

1. A pellicle for extreme ultraviolet (EUV) lithography, with a core layer formed on a pellicle frame,
the core layer comprising:
a first layer comprising silicon; and
a second layer formed on at least one of an upper side and a lower side of the first layer, and comprising one among a metal silicide that has silicon with metal, a silicon compound that has silicon with a light element, and a metal silicide compound that has silicon with metal and a light element.

2. The pellicle for EUV lithography according to claim 1, wherein the light element comprises one or more among oxygen (O), nitrogen (N), and carbon(C).

3. The pellicle for EUV lithography according to claim 1 or 2, wherein the metal comprises one or more between molybdenum (Mo) and ruthenium (Ru).

4. The pellicle for EUV lithography according to anyone of claims 1 to 3, wherein the second layer comprises one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2) and RuSi_{X}C_{Y}O_{Z} (X = 0-3, Y=0-2, Z=0-2).

5. The pellicle for EUV lithography according to any one of claims 1 to 4, wherein the second layer is formed on each side of the first layer.

6. The pellicle for EUV lithography according to any one of claims 1 to 4, wherein the second layer is formed on only the upper side of the first layer.

7. The pellicle for EUV lithography according to anyone of claims 1 to 6, wherein the first layer comprises monocrystalline silicon.

8. The pellicle for EUV lithography according to anyone of claims 1 to 7, further comprising a capping layer formed on at least one between an upper side and a lower side of the core layer, and the capping layer comprises one among a metal silicide that has silicon with metal, a silicon compound that has silicon with a light element, and a metal silicide compound that has silicon with metal and a light element.

9. The pellicle for EUV lithography according to claim 8, wherein the capping layer comprises one among SiN_{X} (X = 0.5-2), SiC_{X} (X = 0.1-2), SiC_{X}O_{2-X} (X = 0-2), MSi_{X} (M : metal, X = 0.3-4), MoSi_{X}C_{Y}O_{Z} (X = 0.5-4, Y=0-2, Z=0-2), and RuSi_{X}C_{Y}O_{Z} (X = 0-3, Y=0-2, Z=0-2).

10. The pellicle for EUV lithography according to claim 8 or 9, wherein an interface layer is formed at an interface between the core layer and the capping layer, an interface between the first layer and the second layer, or an interface between a plurality of capping layers; or a surface layer is formed on a surface of an outermost layer of the capping layers having a multi-layered thin film structure.

11. The pellicle for EUV lithography according to anyone of claims 1 to 10, wherein:
- the core layer has transmittance higher than or equal to 85% and reflectivity lower than or equal to 1% with respect to EUV exposure light; and/or
- the core layer has a thickness lower than or equal to 100nm.

12. The pellicle for EUV lithography according to anyone of claims 8 to 11, wherein materials of a plurality of layers formed by the core layer and the capping layer are stacked in order along an incident direction of exposure light by one of the following structures:
SiCₓO_{y}/MoSi_{X}C_{Y}O_{Z}/SiNₓ/Si/SiCₓO_{y};
SiCₓO_{y}/MoSi_{X}C_{Y}O_{Z}/Si/SiNₓ;
MoSi_{X}C_{Y}O_{Z}/SiNₓ/Si/SiCₓO_{y};
MoSiₓC_{Y}O_{Z}/Si/SiNₓ;
RuSiₓ/SiNₓ/Si/SiCₓO_{y};
RuSi_{X}C_{Y}O_{Z}/Si/SiNₓ;
SiNₓ/Si/MoSi_{X}C_{Y}O_{Z}/SiCₓO_{y};
SiNₓ/Si/MoSi_{X}C_{Y}O_{Z};
SiNₓ/Si/RuSi_{X}C_{Y}O_{Z};
SiCₓO_{y}/MoSi_{X}C_{Y}O_{Z}/Si/SiCₓO_{y};
SiCₓO_{y}/Si/MoSi_{X}C_{Y}O_{Z}/SiCₓO_{y};
MoSi_{X}C_{Y}O_{Z}/Si/SiCₓO_{y};
SiCₓO_{y}/Si/MoSi_{X}C_{Y}O_{Z};
RuSi_{X}C_{Y}O_{Z}/Si/SiCₓO_{y};
and
SiCₓO_{y}/Si/RuSi_{X}C_{Y}O_{Z}.

13. A method of manufacturing a pellicle for extreme ultraviolet (EUV) lithography, the method comprising:
forming an etching stop layer on a substrate;
forming a core layer on the etching stop layer;
forming an etching protective layer on the core layer, and forming an etching mask layer pattern beneath the substrate;
forming a pellicle frame by etching a lower portion of the substrate and the etching stop layer through the etching mask layer pattern; and
removing the etching protective layer,
the core layer comprising:
a first layer comprising silicon; and
a second layer formed on at least one of an upper side and a lower side of the first layer, and comprising one among a metal silicide that has silicon with metal, a silicon compound that has silicon with a light element, and a metal silicide compound that has silicon with metal and a light element.

14. A method of manufacturing a pellicle for extreme ultraviolet (EUV) lithography, using a silicon-on-insulator (SOI) substrate having a structure that a silicon substrate layer, an insulating layer, and a silicon layer are stacked in sequence, while regarding the silicon substrate layer as a pellicle frame, regarding the silicon layer as a first layer of a core layer, and regarding the insulating layer as an etching stop layer, the method comprising:
forming a second layer, which comprises one among a metal silicide that has silicon with metal, a silicon compound that has silicon with a light element, and a metal silicide compound that has silicon with metal and a light element, on the first layer of the core layer;
forming an etching protective layer above the second layer and forming an etching mask layer pattern below the silicon substrate layer;
forming the pellicle frame by etching a lower portion of the silicon substrate layer through the etching mask layer pattern; and
removing the etching protective layer.

15. The method according to claim 13 or 14, further comprising forming a capping layer at least either above or below the core layer.

16. The method according to claim 15, wherein the capping layer formed above the core layer is formed before forming the etching protective layer.

17. The method according to claim 15, wherein the capping layer formed above the core layer is formed after removing the etching protective layer.

18. The method according to claim 15, wherein the capping layer formed below the core layer is formed before forming the core layer.

19. The method according to claim 15, wherein the capping layer formed below the core layer is formed after forming the pellicle frame.

20. The method according to anyone of claims 13 to 19, wherein the core layer or the capping layer is formed based on sputtering using a sputtering target having a composition of silicon/metal=0.05-20, or a sputtering target having a composition of compound (of one or more among O, C, and N)/silicon=0.1-4, at a temperature of 20-600 °C.

21. The method according to anyone of claims 15 to 20, wherein the capping layer is annealed at a temperature higher than or equal to 150 °C under an atmosphere of nitrogen (N), argon (Ar), hydrogen (H), hydrocarbon, or a mixture thereof.
